# EUROPEAN PATENT APPLICATION

(11) **EP 4 411 400 A1**
(43) Date of publication of application: **07.08.2024**
(21) Application number: 23154204.4
(22) Date of filing: 31.01.2023
(51) Int. Cl.: G01R 31/364, G01R 31/389

(54) **SPECTROMETRY PLUG FOR A BATTERY PACK IN AN ELECTRIC MOBILITY APPLICATION AND BATTERY PACK**

(71) Applicant: Heimdalytics GmbH, 24145 Kiel (DE)
(72) Inventor: VAN ZEYL, Clemens, Oakvil, L6J 3Y5 (CA)
(74) Representative: Maiwald GmbH

(57) **Abstract**

The invention relates to a Spectrometry plug (200) for a Battery Pack (120) of an electrical mobile vehicle, craft, vessel, airplane, helicopter or drone, and for performing external spectrometry measurement. The Battery Pack (120) comprises Battery Units (110) with Measurable Battery Groups and components accompanying the Battery Units (110), the Battery Pack (120) is enclosed by a housing, and the spectrometry plug (200) is configured to connect the Measurable Battery Groups (104) with spectrometry hardware devices external to the Battery Pack (120).

## Description

### Technical Field

The invention relates to a spectrometry plug for a Battery Pack, and a Battery Pack.

### Background

A Battery Pack comprises Battery Units with one or more Measurable Battery Groups, interconnections, a battery management system, contactor, overcurrent protections and sensors

Against the background of the widespread market introduction of battery electrical energy storage ("EES"), it is increasingly important to perform an in-depth analysis of the batteries to accurately determine their state. Spectrometry is one means of achieving this goal through the measurement and analysis of a battery's impedance over a band of frequencies. Specifically, spectrometry can accurately determine a battery's state of health ("SoH") and state of charge ("SoC"), plus other states. While spectrometry analysis can be added to a conventional battery management system ("BMS"), which measures the voltage, current and temperature of a battery, for many applications the full integration of spectrometry is undesirable. Such an application is electric vehicles (EV) where cost and energy density are high priority goals. Another application is electric airplanes.

Further, in these applications multiple batteries are then mounted in an enclosure along with interconnections, a battery management system, contactors, overcurrent protections and sensors to form an enclosed package of batteries (a "Battery Pack") for robustness and safety, thereby rendering the batteries inaccessible to perform periodic measurement utilizing spectrometry instrumentation. Today's state of the art batteries maybe in the form of cells within a rigid casing in a cylindrical or prismatic format (an "Encased Battery"), or cells encased in polymer pouch with multiple pouches packaged together to form a module (a "Pouch Battery Module"). Regardless of the configuration, cells are organized into measurable groups for monitoring by the BMS (a "Measurable Battery Group"). Hence, a Battery Pack has multiple Measurable Battery Groups measured and managed by the BMS. The term "Measurable Battery Group" in this disclosure relates to such a Measurable Battery Group.

### Summary

There may be a desire to improve the measurement of the Measurable Battery Groups within a Battery Pack utilizing spectrometry.

The problem is solved by the subject-matter of the independent claims. Embodiments are provided by the dependent claims, the following description and the accompanying figures

The described embodiments similarly pertain to the spectrometry plug and the Battery Pack. Synergetic effects may arise from different combinations of the embodiments although they might not be described in detail.

This disclosure is concerned with periodic spectrometry measurement while minimizing the cost and energy density impact to the Battery Pack. The purpose of periodic spectrometry measurement is to either determine a Measurable Battery Group's SoH or SoC or other state or any combination thereof. Accurate measurement of a Measurable Battery Group's SoH enables timely removal of unhealthy batteries from service to prevent incidents. For example, a quality check prior to shipment of an electric vehicle by an ocean vessel where a faulty battery could lead to a catastrophic event. Accurate measurement of a Measurable Battery Group's SoC enables resetting its SoC algorithm to eliminate errors that accumulate over time. For example, in heavy-use electric vehicles where accurate SoC is necessary to prevent inadvertent vehicle shutdown.

Spectrometry entails excitation of one or more Measurable Battery Groups within a battery system over a spectrum of frequencies utilizing a current source such as an excitation unit, and a means of measuring the response of the excited Measurable Battery Groups. Measurement of each Measurable Battery Group is by one, or more, highly accurate analogue to digital converter(s) commonly interconnected to multiple Measurable Battery Groups using a multiplexer, collectively called a "Battery Measurement Unit" or "BMU". A group of Measurable Battery Groups measured by a single BMU is called a "Battery Unit". A Pouch Battery Module may or may not be a Battery Unit, depending on the number of BMUs installed.

According to a first aspect, a spectrometry plug for a Battery Pack of an electric mobility vehicle, craft, vessel, airplane, helicopter or drone, and for performing external spectrometry measurements is provided. The Battery Pack comprises Battery Units with one or more Measurable Battery Groups, and components accompanying the Battery Units interconnections, such as a battery management system, contactor, overcurrent protections and sensors. The Battery Pack is enclosed by a housing. The spectrometry plug is configured to connect the Measurable Battery Groups with spectrometry hardware devices external to the Battery Pack.

The spectrometry plug is therefore an interface between the internal of the Battery Pack and external devices such as a diagnostic unit, excitation unit and other units responsible for the spectrometry measurements. In this way, the Measurable Battery Groups that are located within the housing of a Battery Pack can be accessed from outside the Battery Pack for spectrometry measurements. The interface may be realized as a plug including cables inside the Battery Pack, and may also contain wireless communication devices for transmitting measurement data, as described in more detail in the following. By the wording "connect the Measurable Battery Groups with spectrometry hardware devices" the connection of the Measurable Battery Groups as part of the Battery Units is not excluded, as described in the following.

According to an embodiment, the spectrometry plug comprises an excitation interface to an excitation unit for exciting the Measurable Battery Groups.

The excitation interface may be an interface realized in hardware. The hardware is, for example, a plug with cables that transmit the excitation signal to either the string of Battery Units, individual Battery Units, or the Measurable Battery Groups. Such a plug for the excitation signals is also referred to as spectrometry excitation signal plug in this disclosure. In other words, the spectrometry plug may be a spectrometry excitation signal plug or at least comprise a spectrometry excitation signal plug.

According to an embodiment, the spectrometry interface comprises a measurement interface to at least one battery measurement unit, BMU, external to the Battery Pack for performing battery spectrometry measurements for the Measurable Battery Groups.

This embodiment relates to a first configuration, where the BMUs are external to the Battery Pack.

In contrast to the excitation interface, the measurement interface is configured to receive measurement signals as proposed in this embodiment or already digitized measurement data as proposed in other embodiments, and provide the data to an external unit. In this embodiment, the BMUs are external to the Battery Pack so that a measurement plug realizing a part of the interface is connected directly to the Measurable Battery Groups and carries the measurement signals. The BMUs may perform the measurements and comprise, for example, A/D converters. For all means of spectrometry excitation and measurement, analysis of the measured data by the BMUs is required to diagnose a battery's state, and in particular a battery's SoH and SoC. This analysis and diagnosis is performed by one or more digital processing controllers along with data storage and management (a "Diagnostic Unit"), which may be complemented with remote cloud computing. This diagnostic unit is located external to the Battery Pack. Therefore, the digital measurement results may then be sent from the external BMUs to the external diagnostic unit.

The measurement interface may be realized completely in hardware, using for example cables, or as a wireless interface.

Such a plug for the measurements is also referred to as spectrometry measurement plug in this disclosure. In other words, the spectrometry plug may be a spectrometry measurement plug or at least comprise a spectrometry measurement plug.

The spectrometry measurement plug may be a plug separated from the spectrometry excitation signal plug, or combined with the spectrometry excitation signal plug, which is also referred to as common spectrometry plug in this disclosure. The hardware plugs are the part of the spectrometry plug where the cables end at the transition of the Battery Pack to the outside; i.e. at the housing of the Battery Pack.

According to an embodiment, the Battery Pack further comprises a plurality of BMUs for performing battery spectrometry measurements for the Measurable Battery Groups, wherein each BMU is connected to a respective Battery Unit, and wherein the spectrometry interface comprises a measurement interface to a diagnostic unit.

This embodiment relates to a second configuration, where the BMUs are inside the Battery Pack.

In other words, according to this embodiment, the BMUs, which may perform the measurements and include A/D converters as described above, are inside the Battery Pack and the digital measurement results of the BMUs are output to the measurement interface. The measurement interface in this case is configured to provide the digitized measurement data to the diagnostic unit.

The determining factor as to whether first or second configuration is implemented in an application is often whether an accurate measurement can be achieved with the BMU located remotely from the Battery Units.

According to an embodiment, the BMUs for spectrometry are integrated with the BMUs for the battery management system, BMS, used for battery management, and the spectrometry measurement interface is connected to the BMUs for spectrometry over the BMS.

The BMUs for spectrometry may be integrated with BMUs used for the BMS, as both measure the voltage and current of a Measurable Battery Group. Rephrasing, the BMUs can be used for both, spectrometry, and battery management. The effect of this configuration is fewer components and elimination of an impedance that could affect the spectrometry measurement.

According to an embodiment, each Battery Unit has a positive terminal representing the plus pole of the Battery Unit and a negative terminal representing the negative pole of the Battery Unit, wherein the Battery Units are arranged in series such that the Battery Units form a string with a positive string terminal and a negative string terminal. The excitation interface is configured to conduct the excitation signals from the excitation unit to the positive string terminal and the negative string terminal only.

There may exist multiple strings of Battery Units connected in parallel. In this case, the excitation signals are provided to each positive string terminal and negative string terminal of each string.

According to an embodiment, each Battery Unit has a positive terminal representing the plus pole of the Battery Unit and a negative terminal representing the negative pole of the Battery Unit, wherein the Battery Units are arranged in series, and the excitation interface is configured to conduct the excitation signals from the excitation unit to each terminal of each Battery Unit.

Since the Battery Units within a string are connected in series, terminals between two Battery Units merge to a single terminal.

According to an embodiment, the Measurable Battery Groups within a Battery Unit are arranged in series, the Battery Units are arranged in series, and the excitation interface is configured to conduct the excitation signals from the excitation unit to every Measurable Battery Group.

In other words, the signals are conducted directly to each Measurable Battery Group.

According to an embodiment, the spectrometry plug comprises a de-multiplexer configured to de-multiplex the excitation signal from a line of the excitation signal interface to a Battery Unit to each of the Measurable Battery Groups of the Battery Unit.

In other words, instead of lines from the excitation signal interface to each of the Measurable Battery Groups, a single line to a Battery Unit is provided that carries the excitation signals of all Measurable Battery Groups for this Battery Unit. The signal on this single line is then demultiplexed to the Measurable Battery Groups. Consequently, the number of lines and terminals at the excitation interface can be reduced. There may exist one or more such de-multiplexers in a Battery Pack such that a part of Battery Units or all Battery Units receive the excitation signal from the de-multiplexers.

According to an embodiment, the spectrometry plug further comprises one or more multiplexers for multiplexing the measurement signals of the Measurable Battery Groups of a Battery Unit to a single line of the measurement interface.

There may exist one or more such multiplexers in a spectrometry plug within the Battery Pack such that the signals of a part of Measurable Battery Groups within a Battery Unit or of all Measurable Battery Groups are provided as multiplexed signals to the measurement interface in direction to, for example, the external BMUs.

According to an embodiment, the measurement interface comprises at least one wireless communication device configured to transmit the measurement data from the BMUs to the diagnostic unit wirelessly.

This embodiment relates to the second configuration, where the BMUs are inside the Battery Pack. The digitized data is received from one or a plurality of BMUs by the wireless communication device, which transmits the data to the diagnostic unit. The wireless communication device may be capable to communicate according to one or more communication standards such as Wi-Fi, Bluetooth, Zigbee, 3G, 4G, 5G, etc. or according to a proprietary communication means.

According to an embodiment, the spectrometry plug further comprises a data concentrator, wherein the data concentrator is configured to prepare the measurement data for transmission over a standard mobile communication network, and wherein the measurement interface provides an interface according to the standard mobile communication network.

This embodiment relates to the second configuration. For the communication between the BMUs located within the Battery Pack and the externally located diagnostic unit, the measured data may be transmitted over an existing means within the mobile vehicle, craft, vessel, airplane, helicopter or drone. The existing means may be, for example, a standard EV communication network such as OBD or CanBus that the diagnostic unit can plug into, or a means within the EV vehicle where data is communicated wirelessly from the network to the diagnostic unit.

According to an embodiment, the spectrometry measurement plug comprises further a multiplexer for multiplexing the measurement signals from the Battery Units to external BMUs, or the measurement data from the internal BMUs to a diagnostic unit.

According to an embodiment the spectrometry plug comprises further the excitation signal interface and the measurement signal interface, wherein the excitation signal interface comprises hardware to conduct the excitation signal into the Battery Pack and hardware to conduct the measurement signals or data out of the Battery Pack, and wherein the hardware for the excitation is separated from the hardware of measurement signals or data forming two separate hardware plugs or wherein the hardware for the excitation and the hardware of measurement signals or data are combined forming a single hardware plug.

The spectrometry excitation signal plug and the spectrometry measurement plug may be combined and share a common housing, at least where the plug part external to the Battery Pack is plugged into the plug part mounted at the housing of the Battery Pack, forming a common spectrometry plug. Alternatively, the excitation signal plug and the spectrometry measurement plug do not have a common housing at the housing of the Battery Pack.

According to a second aspect, a Battery Pack for an electrical mobile vehicle, craft, vessel, airplane, helicopter or drone, is provided. The Battery Pack comprises Battery Units with Measurable Battery Groups, the Battery Pack is enclosed by a housing, and the Battery Pack comprises further a spectrometry plug as described herein for performing external spectrometry measurements.

The plug(s) as described herein may have a Battery Pack side part and a removable part, which can be connected to the Battery Pack side part. The interface comprises both parts.

A spectrometry plug and a Battery Pack are provided. The spectrometry plug is used with the Battery Pack for the purpose of periodically determining the state of the Measurable Battery Groups within such Battery Pack with all or a portion of the spectrometry instrumentation being external to the Battery Pack. This plug creates a series of technical possibilities, which allow independent and improved diagnoses of the entire Battery Pack without its disassembly.

These and other features, aspects and advantages of the present invention will become better understood with reference to the accompanying figures and the following description.

### Short Description of the Figures

- Fig. 1: shows a block diagram with definitions.
- Fig. 2: shows a block diagram of a first configuration of the spectrometry plug.
- Fig. 3: shows a block diagram of a second configuration of the spectrometry plug.
- Figs. 4(a) to 4(c): show diagrams illustrating the spectrometry plug for interconnection of the external excitation unit for the first and second configurations.
- Fig. 5: shows a diagram illustrating the spectrometry plug for interconnection of the external BMUs.
- Figs. 6a-6d: show diagrams illustrating different BMU communication variants for the first configuration:

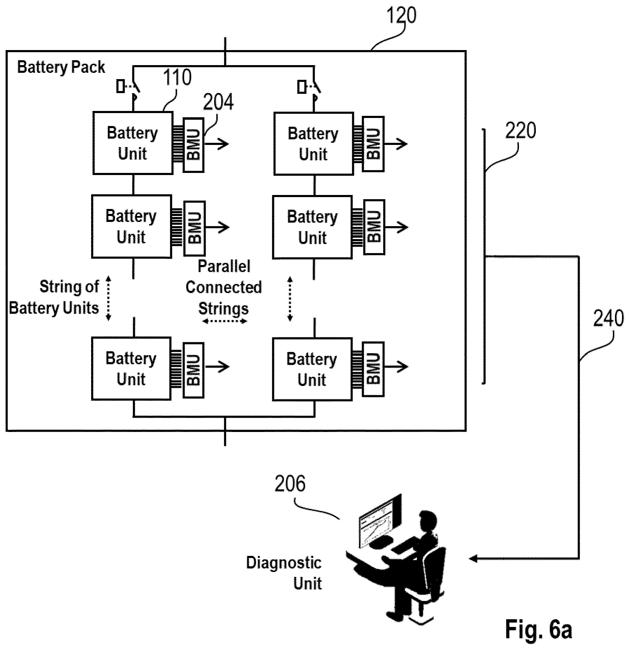

- Fig. 6a: shows a hardwired variant,

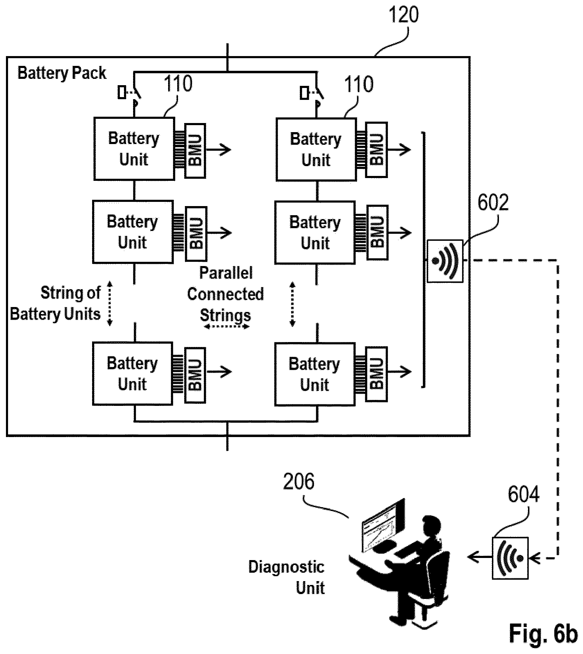

- Fig. 6b: shows a wireless variant,

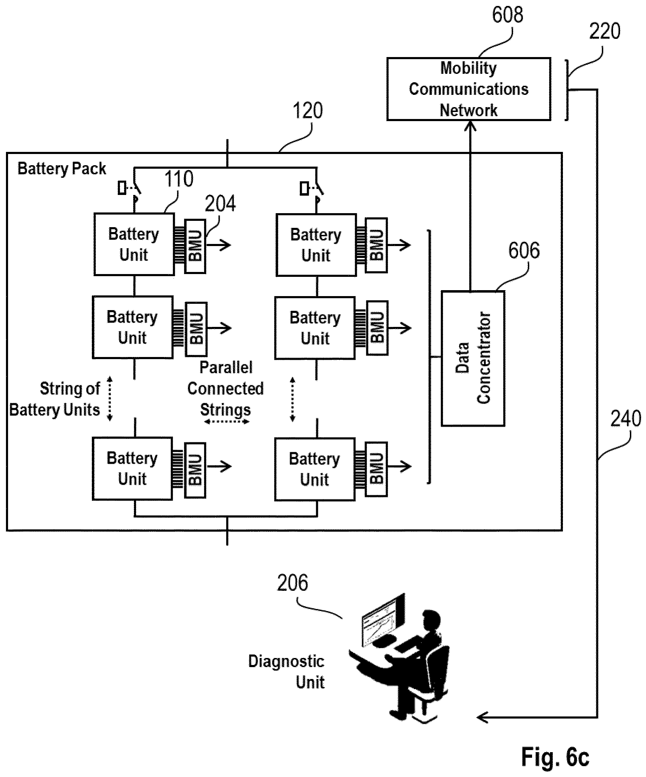

- Fig. 6c: shows a hardwired variant using EVs communication network, and

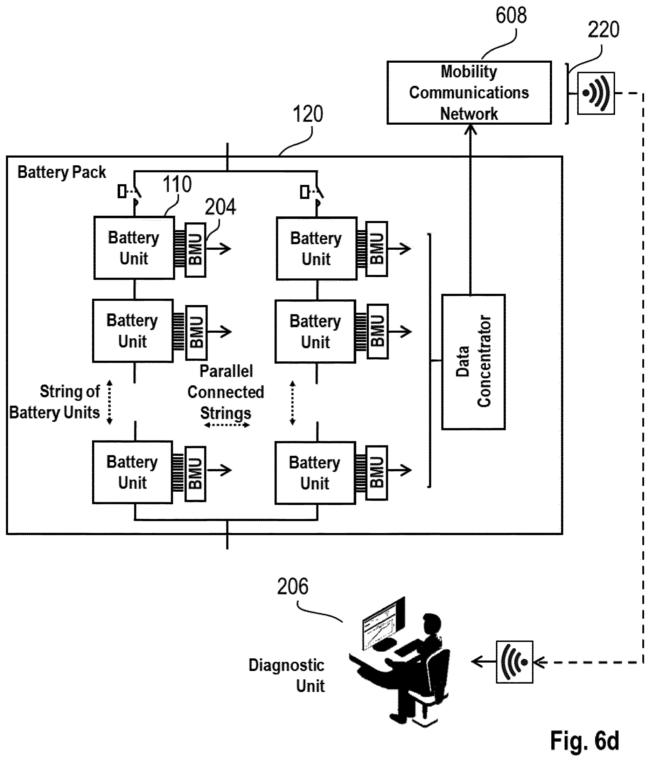

- Fig. 6d: shows a wireless variant using EVs communication network

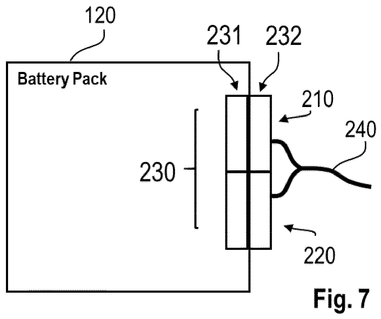

- Fig. 7: shows the diagram of a spectrometry plug.

### Detailed Description of Embodiments

Corresponding parts are provided with the same reference symbols in all figures.

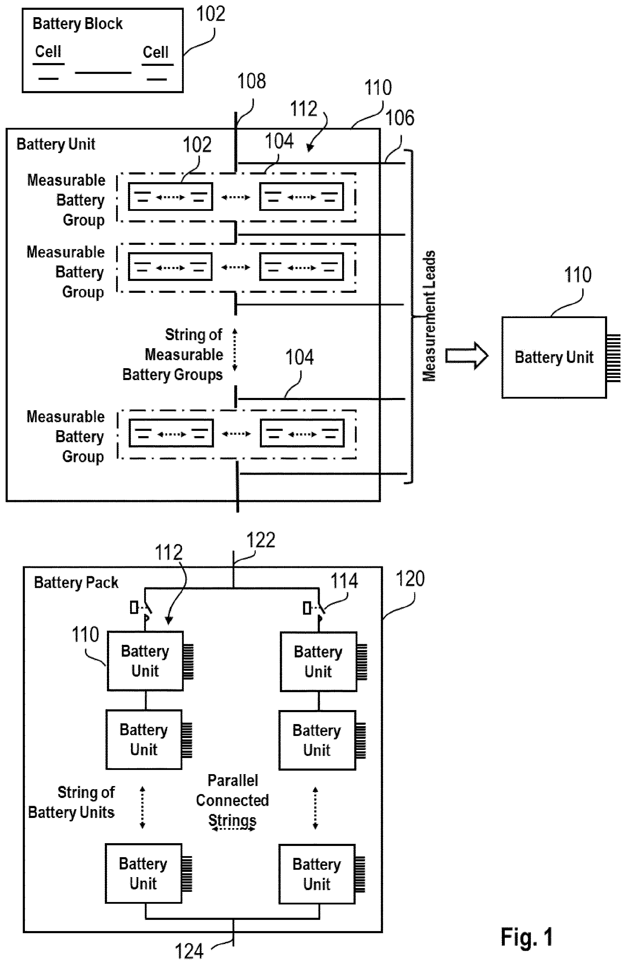

Fig. 1 shows the definition of terms used herein. A basic unit is block 102 with several batteries, herein referred to as a Battery Block 102. A Measurable Battery Group 104 contains one or more Battery Blocks 102. Several Measurable Battery Groups 104 are connected in series thereby forming a string of Measurable Battery Groups called a Battery Unit 112. Each Measurable Battery Group 104 therefore has a positive terminal and a negative terminal, each of which is led out as a measurement lead 106. The block symbol used herein for the Battery Unit 110 with the measurement leads 106 is shown on the right in Fig. 1. The bottom part of Fig. 1 shows a block diagram of the Battery Pack 120. The Battery Pack 120 contains strings 112 of Battery Units 110 that are connected in parallel. The Battery Pack 120 has a positive terminal 122 and a negative terminal 124. A contactor 114 is arranged between each of the strings 112 and the positive terminal 122.

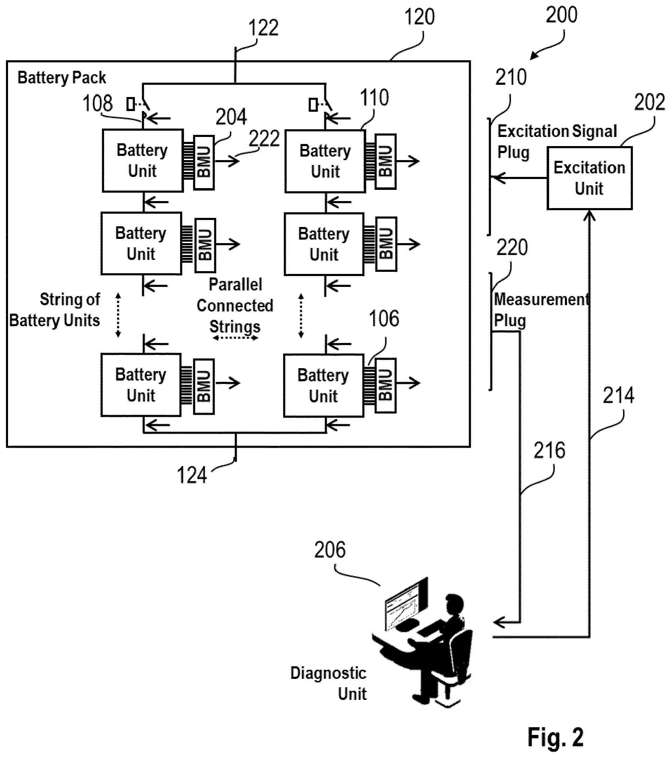

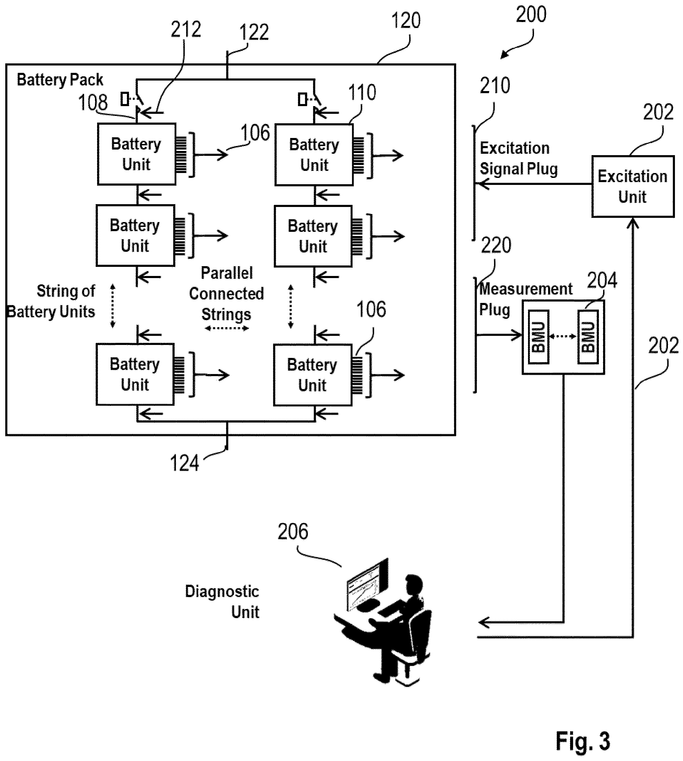

In the following figures, arrows are used to indicate the spectrometry plug(s). There are two types of plugs: a measurement plug representing the measurement interface and an excitation signal plug representing the excitation interface. The arrows showing a direction from the BMU for each Battery Unit 110 to the diagnostic unit 206 (e.g., Fig. 2) or from the Battery Units 110 to external BMUs (e.g. Fig. 3) refer to the measurement plug 220. The arrows showing a direction from the excitation unit 202 to the Battery Units 110 refer to the excitation signal plug 210. The spectrometry plug 200 refers to the measurement plug 220 and the excitation signal plug 210.

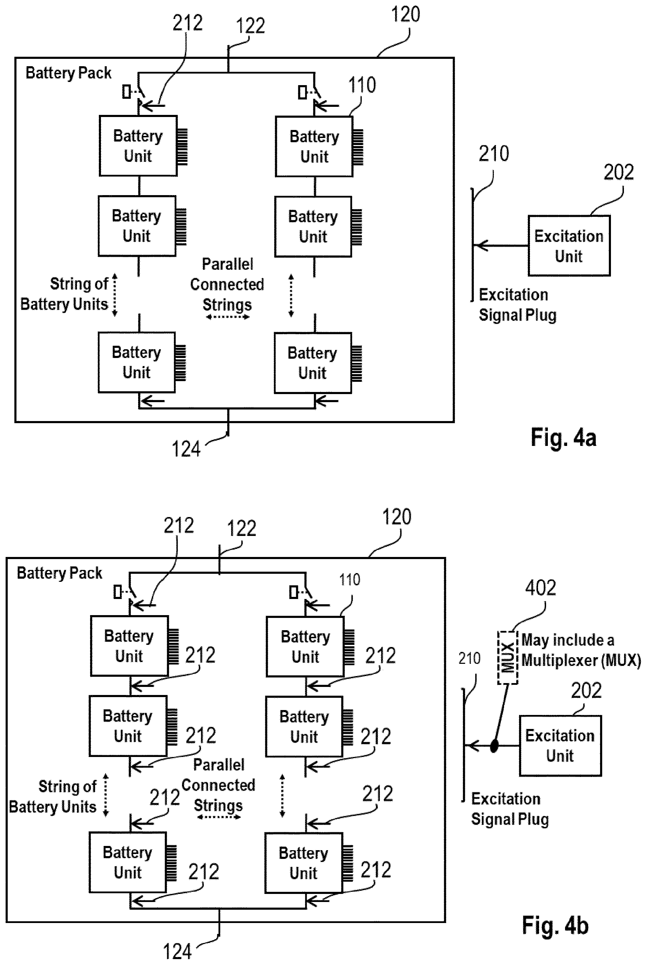

Fig. 2 shows a diagram illustrating a first configuration of a spectrometry plug 200 embedded in battery spectrometry measurement system, where as a first option, the excitation unit is located external to the Battery Pack with the BMUs co-located alongside of the Battery Units inside the Battery Pack. For all means of spectrometry excitation and measurement, analysis of the measured data by the BMUs is required to diagnose a battery's state, and in particular a battery's SoH and SoC. This analysis and diagnosis is performed by one or more digital processing controllers along with data storage and management which may be complemented with remote cloud computing. The digital processing controllers, the data storage and the management are contained in the diagnostic unit 206 as illustrated in Fig. 2. This diagnostic unit 206 is located external to the Battery Pack. The measurement of each Measurable Battery Group 104 as shown in Fig. 1 is performed by one, or more, highly accurate analogue to digital converter(s) (not shown in Fig. 2) commonly interconnected to multiple Measurable Battery Groups using a multiplexer (not shown in Fig. 2). The analogue to digital converter(s) and the multiplexer are illustrated collectively as "battery measurement unit" 204 or "BMU" 204 in Fig. 2. The output 222 of the BMUs 204 is part of the spectrometry interface. It is connected to the spectrometry measurement plug 220. The spectrometry measurement plug 220 connects the BMU outputs 222 with the diagnostic unit 206. The excitation unit 202 is connected to the spectrometry excitation signal plug 210, and the spectrometry excitation signal plug 210 is connected to the Battery Unit terminals 108. The spectrometry plug 200 is comprised of the spectrometry excitation signal plug 210 and spectrometry measurement plug 220 may be realized as a single common spectrometry plug 230 as illustrated in Fig. 7. The diagnostic unit 206 receiving the measurement data from the BMU 204 and controlling the excitation is connected to BMU 204 via the spectrometry measurement plug 220 and is connected to the excitation unit 202 over a wired or wireless connection. In case of wireless transmission of the data from the BMUs, a wireless communication device is arranged in or at the spectrometry measurement plug. Similarly, for controlling the excitation unit 202 wirelessly, a wireless communication device may be arranged at or in the excitation unit 202. Further options for the excitation signal are shown in Figs. 4a to 4c.

It is noted that the arrows for the excitation signal 212 at the Battery Units from the excitation unit are in direction to the Battery Units. However, regarding the direction of currents for the excitation, the excitation unit may contain devices or circuits that serve as source and/or as sink.

Fig. 3 shows a diagram illustrating a second configuration of the spectrometry plug 200, where as a second option, both, the excitation unit 202 and the BMUs 204 are located external to the Battery Pack 120. In this case, the measurement leads 106 are connected to the spectrometry measurement plug 220, which again is connected to the excitation unit 202, and the Battery Unit terminals 108 are connected to the spectrometry excitation signal plug 210. The diagnostic unit 206 receiving the measurement data from the BMU 204 and controlling the excitation is connected to the BMU 204 and the excitation unit 202 over a wired or wireless connection. Further options for the excitation signal are shown in Figs. 4a to 4c.

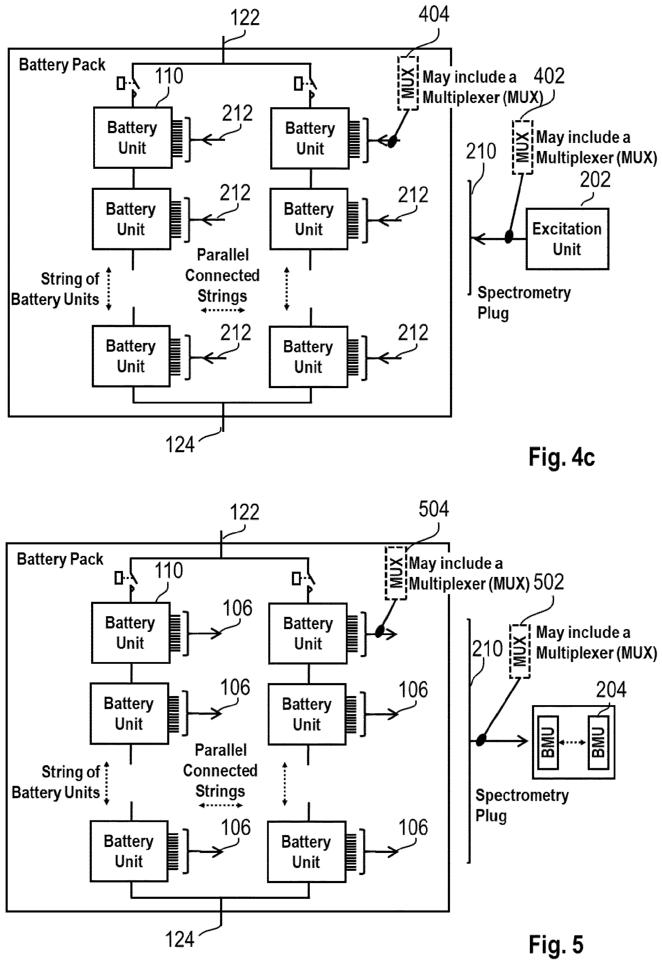

Figs. 4a to 4c illustrate arrangements for the excitation of the Measurable Battery Groups 212. Regarding the externally located excitation unit 202, the common spectrometry plug 230, or excitation signal plug 210 can either be configured to excite all the Battery Units 110 within the Battery Pack 120, or a portion thereof including each Battery Unit 110, or each Measurable Battery Group 104 within a Battery Unit 110. In Figs. 4a to 4c, only the excitation unit 202 is shown for simplicity. In Fig. 4a, all Battery Units within a string are excited through connections 212 at each end, i.e., the positive string terminal and the negative string terminal of the respective string. In Fig. 4b, all Battery Units in the Battery Pack 120 are excited individually. In Fig. 4c, each of the Measurable Battery Group 104 in each Battery Unit 110 is excited individually. Further, variants as shown in Fig. 4b and in Fig. 4c may, or may not, include multiplexers 402 and/or 404 to reduce the amount interconnections required. In cases where multiplexer(s) are included in the circuit, it connects a single excitation unit 202 to multiple Battery Units 110 or Measurable Battery Groups 104, depending on the circuit layout.

In the second configuration as shown in Fig. 3, where the BMUs 204 are external to the Battery Pack 120, the spectrometry excitation signal plug 220 or the common spectrometry plug 230 directly access each Measurable Battery Group 104 within the Battery Pack 120 for measurement by the externally located BMUs 204. The spectrometry plug 220, 230 may be arranged such that either, (a) each Measurable Battery Group is paired with a BMU 204 for one-to-one direct access, or (b) the Measurable Battery Groups within each Battery Unit, or a portion thereof, are multiplexed by a multiplexer 502 such that a set of Measurable Battery Groups are measured, one at a time, by a single BMU 204, or (c) a multiplexer 504 is located with each Battery Unit 110. These variants are illustrated in Fig. 5, which only shows the BMU(s) for simplicity instead of BMU(s) and excitation unit (202).

In the second configuration, a common communication means between the diagnostic unit 206 and BMUs 204 is possible as the units are both external to the Battery Pack 120. In the first configuration, however, communication is required between the BMUs 204 located within the Battery Pack 120 and the externally located diagnostic unit 206. This communication of the measured data can be either, (a) over the spectrometry plug 220, 230, and a cable 240 as shown in Fig. 6a, or (b) by a wireless means 602, 604 (for example Bluetooth or Wi-Fi) as shown in Fig. 6a, or (c) over an existing means within the electric mobility vehicle, craft, vessel, airplane, helicopter or drone (for example OBD or CanBus for electric vehicles) that the diagnostic unit 206 can plug into, as shown in Fig. 6c, or (d) over an existing means within the electric mobility vehicle, craft, vessel, airplane, helicopter or drone where data is communicated wirelessly from the network 608 to the diagnostic unit 206 as shown in Fig. 6d. Figs. 6a to 6d only show the BMU(s) 204 for simplicity instead of BMU(s) 204 and excitation unit (202).

As shown in Figs. 6c and 6d, the Battery Pack may comprise also a data concentrator 606 connected to the BMUs 204, whose purpose is to collect the measurement data from the BMUs 204 and to prepare the measurement data such that they are available according to the protocol of the existing communication network 608 of the electric mobility vehicle, craft, vessel, airplane, helicopter or drone 608. The mobility network may be a wired or a wireless network or a mix of it. The protocols usually have a specification comprising several layers including network layer, data layer and physical layers and the like known to a skilled person.

Fig. 7 shows the spectrometry excitation signal plug 210 and the spectrometry measurement plug 220, which may be separated plugs 210, 220 or combined having a common encasing, such that they form a single plug 230, herein referred to as "common spectrometry plug" 230. The plug(s) 210, 220, 230 have a Battery Pack side 231 mounted to within the casing of the Battery Pack 120 and a cable side 232 at the end of cable 240. In case of wireless data transmission, the spectrometry measurement plug 220 would consist of the Battery Pack side 231 plug, which may be an interface to a wireless communication device 602, 604 as shown in Fig. 6b within the Battery Pack. In embodiments, the wireless communication device 602 may comprise a plug that fits into the Battery Pack side 231 of the spectrometry measurement plug 220.

Other variations to the disclosed embodiments can be understood and effected by those skilled in the art in practicing the claimed invention, from the study of the drawings, the disclosure, and the appended claims. In the claims, the word "comprising" does not exclude other elements or steps and the indefinite article "a" or "an" does not exclude a plurality. A single processor or other unit may fulfill the functions of several items or steps recited in the claims. The mere fact that certain measures are recited in mutually different dependent claims does not indicate that a combination of these measures cannot be used to advantage. Any reference signs in the claims should not be construed as limiting the scope of the claims.

### Reference Numerals

- 102: battery cell block
- 104: Measurable Battery Group
- 106: measurement lead from the Measurable Battery Group
- 108: Measurable Battery Group terminal
- 110: Battery Unit
- 112: string of Measurable Battery Groups
- 114: contactor
- 120: Battery Pack
- 122: positive terminal of the Battery Pack
- 124: negative terminal of the Battery Pack
- 200: spectrometry plug
- 202: excitation unit
- 204: battery management unit (BMU)
- 206: diagnostic unit
- 210: excitation signal plug for input to Battery Pack
- 212: excitation signal lead to one or more Measurable Battery Groups from the excitation unit
- 220: measurement plug
- 212: output to the diagnostic unit
- 230: common spectrometry plug
- 231: Battery Pack side of the plug(s)
- 232: cable side of the plug(s)
- 240: cable
- 402: de-multiplexer
- 404: de-multiplexer
- 502: multiplexer
- 504: multiplexer
- 602: wireless communication device / transmitter
- 604: wireless communication device / transmitter
- 606: data concentrator
- 608: electric mobility communications network

## Claims

1. Spectrometry plug (200) for a Battery Pack (120) of an electric mobility vehicle, craft, vessel, airplane, helicopter or drone, and for performing external spectrometry measurements wherein the Battery Pack (120) comprises Battery Units (110) with one or more Measurable Battery Groups (104) and components accompanying the Battery Units (110), wherein the Battery Pack (120) is enclosed by a housing; and
wherein the spectrometry plug (200) is configured to connect the Measurable Battery Groups (104) with spectrometry hardware devices external to the Battery Pack (120).

2. Spectrometry plug (200) according to claim 1, wherein the spectrometry plug (200) comprises an excitation interface to an excitation unit (202) for exciting the Measurable Battery Groups (104).

3. Spectrometry plug (200) according to claim 1 or 2, wherein the spectrometry interface comprises a measurement interface to at least one battery measurement unit, BMU, external to the Battery Pack (120) for performing battery spectrometry measurements for the Measurable Battery Groups (104).

4. Spectrometry plug (200) according to claim 1 or 2, wherein the Battery Pack (120) further comprises a plurality of BMUs (204) for performing battery spectrometry measurements for the Measurable Battery Groups (104), wherein each BMU (204) is connected to a respective Battery Unit (110), and wherein the spectrometry interface comprises an measurement interface to a diagnostic unit (206).

5. Spectrometry plug (200) according to claims 3 or 4, wherein the BMUs (204) for spectrometry are integrated with the BMUs (204) for the battery management system, BMS, used for battery management, and the spectrometry measurement interface is connected to the BMUs (204) for spectrometry over the BMS.

6. Spectrometry plug (200) according to any one of claims 2 to 5, wherein each Battery Unit (110) has a positive terminal representing the plus pole of the Battery Unit (110) and a negative terminal representing the negative pole of the Battery Unit (110), wherein the Battery Units (110) are arranged in series such that the Battery Units (110) form a string (112) with a positive string terminal and a negative string terminal;
wherein the excitation interface is configured to conduct the excitation signals from the excitation unit (202) to the positive string terminal and the negative string terminal only.

7. Spectrometry plug (200) according to any one of claims 2 to 5, wherein each Battery Unit (110) has a positive terminal representing the plus pole of the Battery Unit (110) and a negative terminal representing the negative pole of the Battery Unit (110), wherein the Battery Units (110) are arranged in series; and
wherein the excitation interface is configured to conduct the excitation signals from the excitation unit (202) to each terminal of each Battery Unit (110).

8. Spectrometry plug (200) according to any one of claims 2 to 5, wherein the Measurable Battery Groups (104) within a Battery Unit (110) are arranged in series, and the Battery Units (110) are arranged in series; and
wherein the excitation interface is configured to conduct the excitation signals from the excitation unit (202) to every Measurable Battery Group.

9. Spectrometry plug (200) according to the previous claim, wherein the spectrometry plug (200) comprises a de-multiplexer (404) configured to de-multiplex the excitation signal from a line of the excitation signal interface to a Battery Unit (110) to each of the Measurable Battery Groups (104) of the Battery Unit (110).

10. Spectrometry plug (200) according to claim 3 and any one of claims 5 to 9, wherein the spectrometry plug (200) further comprises one or more multiplexers (504) for multiplexing the measurement signals of the Measurable Battery Groups (104) of a Battery Unit (110) to a single line of the measurement interface.

11. Spectrometry plug (200) according to any one of claims 4 to 10, wherein the measurement interface comprises at least one wireless communication device (602) configured to transmit the measurement data from the BMUs (204) to the diagnostic unit (206) wirelessly.

12. Spectrometry plug (200) according to any one of claims 4 to 10, wherein the spectrometry plug (200) further comprises a data concentrator (606), wherein the data concentrator is configured to prepare the measurement data for transmission over a standard mobile communication network, and wherein the measurement interface provides an interface according to the standard mobile communication network.

13. Spectrometry measurement plug according to any one of claims 3 to 12, comprising further a multiplexer (502) for multiplexing the measurement signals from the Battery Units (110) to external BMUs (204), or the measurement data from the internal BMUs (204) to a diagnostic unit (206).

14. Spectrometry plug (200) according to any one of claims 3 to 11, wherein the spectrometry plug (200) comprises the excitation signal interface and the measurement signal interface,
wherein the excitation signal interface comprises hardware to conduct the excitation signal into the Battery Pack (120) and hardware to conduct the measurement signals or data out of the Battery Pack (120); and
wherein the hardware for the excitation is separated from the hardware of measurement signals or data forming two separate hardware plugs or wherein the hardware for the excitation and the hardware of measurement signals or data are combined forming a single hardware plug.

15. Battery Pack (120) for an electrical mobile vehicle, craft, vessel, airplane, helicopter or drone, wherein
the Battery Pack (120) comprises Battery Units (110) with Measurable Battery Groups (104);
the Battery Pack (120) is enclosed by a housing; and wherein
the Battery Pack (120) comprises further a spectrometry plug (200) according to any of the previous claims for performing external spectrometry measurements.
